# EUROPEAN PATENT APPLICATION

(11) **EP 4 659 930 A1**
(43) Date of publication of application: **10.12.2025**
(21) Application number: 23919816.1
(22) Date of filing: 18.08.2023
(51) Int. Cl.: B29C 43/34, B29C 43/18, H01L 21/56

(54) **COMPRESSION-MOLDING DEVICE AND COMPRESSION-MOLDING METHOD**

(30) Priority: 30.01.2023 JP 2023011558
(71) Applicant: Apic Yamada Corporation, Chikuma-shi, Nagano 389-0898 (JP)
(72) Inventor: WAKUI, Masaaki, Chikuma-shi, Nagano 389-0898 (JP); SAITO, Takashi, Chikuma-shi, Nagano 389-0898 (JP); KAWAGUCHI, Makoto, Chikuma-shi, Nagano 389-0898 (JP); NOMURA, Yudai, Chikuma-shi, Nagano 389-0898 (JP)
(74) Representative: Winter, Brandl - Partnerschaft mbB
(86) International application number: PCT/JP2023/029785
(87) International publication number: WO 2024/161680

(57) **Abstract**

The present invention addresses the problem of providing a compression-molding device and a compression-molding method which make it possible to prevent molding failures from occurring. A compression-molding device (1) according to the present invention comprises: an upper mold half (204) having a cavity (208); a lower mold half (206) having a workpiece-holding part (205); and a conveyor (302) which places a sealing resin (R) on a workpiece (W) held in the workpiece-holding part (205) or makes the workpiece-holding part (205) hold a workpiece (W) having a sealing resin (R) placed thereon. As the sealing resin (R), a solid/semi-solid resin which as a whole has a given shape corresponding to the shape of the workpiece (W) is used.

## Description

### Technical Field

The present invention relates to a compression-molding device and a compression-molding method.

### Related Art

As an example of a resin sealing device and a resin sealing method for processing a workpiece, in which electronic parts are mounted on a substrate, into a molded product by sealing with sealing resin, those using a compression-molding approach is known.

The compression-molding approach is a technology for resin sealing by supplying a given amount of sealing resin to a sealing area (cavity) provided in a sealing mold composed of an upper mold and a lower mold, arranging a workpiece in the sealing area, and clamping with the upper mold and the lower mold. As one example, in the case of using a sealing mold with a cavity in the upper mold, a technology for molding by supplying sealing resin collectively to the center position on the workpiece is known. On the other hand, in the case of using a sealing mold with a cavity in the lower mold, a technology for molding by supplying a release film (hereinafter, may be simply referred to as "film") covering the mold face including the cavity and sealing resin is known (Patent Document 1: Japanese Patent Application Laid-Open Publication No. 2019-145550).

### Citation List

### Patent Literature

Patent Document 1: Japanese Patent Application Laid-Open Publication No. 2019-145550

### SUMMARY OF INVENTION

### Technical Problem

For example, in the case of resin sealing electronic parts (semiconductor chips) with wire-connections of a strip type as a workpiece, in the compression-molding approach where a cavity is provided in the upper mold, there was a problem that resin sealing is difficult because the wire part of the workpiece held on the lower mold contacts and deforms due to the sealing resin supplied in advance to the cavity or the sealing resin supplied on the workpiece. Therefore, generally, a compression-molding approach was adopted in which the workpiece is held on the upper mold, the cavity is provided in the lower mold, and sealing resin (as one example, granular resin) is supplied into the cavity.

However, in the configuration where the workpiece is held on the upper mold and the cavity is provided in the lower mold, there was a problem that when the workpiece is thin or large, it is difficult to hold it on the upper mold and it tends to fall. Moreover, normally, the configuration is such that sealing resin is supplied into the cavity of the lower mold with a film interposed, but when trying to form a molded product with a thickness (here, the thickness of the resin portion after molding) exceeding 1mm, there was a problem that the molding stroke becomes large, making it easy for molding failures to occur where the film bites into the molded product. Furthermore, when granular resin is configured as the sealing resin, the above-mentioned film biting is likely to occur. In addition, besides the problems of dust generation and difficult handling, there was a problem that it is difficult to supply (scatter) sealing resin evenly to the entire area of the cavity provided in the lower mold, resulting in uneven scattering. Moreover, there was a problem that molding failures easily occur where air contained in the gaps between particles during the scattering of sealing resin remains in the molded product without being released. Especially in the case of a workpiece where electronic parts are mounted by wire-connection, there was also a risk of wire flow (deformation or cutting of wires) due to resin flow in the cavity during resin sealing.

### Solution to Problem

The present invention has been made in view of the above circumstances, and aims to provide a compression-molding device and a compression-molding method which, by adopting a configuration where the cavity is provided in the upper mold, solves the above problems in the configuration where the cavity is provided in the lower mold, while preventing the occurrence of molding failures due to sealing resin flow, uneven scattering, and residual air, and which is capable of forming molded products with large thickness dimensions, and furthermore, allows easy handling of sealing resin and prevents the generation of dust.

The present invention solves the aforementioned problems by the solution means described below as one embodiment.

A compression-molding device according to one embodiment processes a workpiece into a molded product by sealing it with a sealing resin by using a sealing mold including an upper mold having a cavity and a lower mold having a workpiece-holding part. The compression-molding device includes a conveyor that places the sealing resin on top of the workpiece held in the workpiece-holding part, or holds the workpiece with the sealing resin placed thereon in the workpiece-holding part, and as the sealing resin, a solid or semi-solid resin having a given shape whose overall shape corresponds to a shape of the workpiece is configured. For example, as the workpiece, a workpiece having a configuration in which electronic parts are mounted on a substrate is configured. Moreover, as the sealing resin, a solid or semi-solid resin formed in a shape that does not contact the electronic parts when placed on the substrate are configured. In particular, as the sealing resin, a configuration having a plate-shaped or block-shaped main body part and legs erected on one face of the main body part is preferable.

According to the above embodiment, by the configuration in which the cavity is provided in the upper mold and the workpiece is held in the lower mold, it is possible to eliminate the problem of the workpiece falling. Moreover, it is possible to prevent the occurrence of molding failures due to sealing resin flow, uneven scattering, and residual air. Furthermore, even in the case of forming thick molded products with thickness dimensions exceeding 1mm, it is possible to prevent film biting. In addition, it is possible to facilitate the handling of the sealing resin and prevent the generation of dust.

Moreover, a compression-molding method according to one embodiment processes a workpiece into a molded product by sealing it with a sealing resin by using a sealing mold including an upper mold having a cavity and a lower mold having a workpiece-holding part. The compression-molding method includes a resin preparation step of preparing, as the sealing resin, a solid or semi-solid resin having a given shape whose overall shape corresponds to a shape of the workpiece; a workpiece holding step of holding the workpiece in the workpiece-holding part; and a resin placement step of placing the sealing resin on top of the workpiece after or before the workpiece holding step. For example, as the workpiece, a workpiece having a configuration in which electronic parts are mounted on a substrate is configured. Moreover, as the sealing resin, a solid or semi-solid resin formed in a shape that does not contact the electronic parts when placed on the substrate is configured. In particular, as the sealing resin, a configuration having a plate-shaped or block-shaped main body part and legs erected on one face of the main body part is preferable.

### Effects of Invention

According to the present invention, by adopting a configuration in which the cavity is provided in the upper mold, it is possible to solve the aforementioned problems in the configuration where the cavity is provided in the lower mold. In particular, it is possible to prevent the occurrence of molding failures due to sealing resin flow, uneven scattering, and residual air. Moreover, it is possible to form thick molded products with thickness dimensions exceeding 1mm. In addition, it is possible to facilitate the handling of the sealing resin and prevent the generation of dust.

### BRIEF DESCRIPTION OF DRAWINGS

[FIG. 1] FIG. 1 is a plan view showing an example of a compression-molding device according to an embodiment of the present invention.
[FIG. 2] FIG. 2 is a side view showing an example of a press device of the compression-molding device of FIG. 1.
[FIG. 3] FIG. 3 is a front sectional view showing an example of a sealing mold of the compression-molding device of FIG. 1.
[FIG. 4] FIG. 4 is an explanatory diagram of a compression-molding method according to an embodiment of the present invention.
[FIG. 5] FIG. 5A is an enlarged view of part V in FIG. 4. FIG. 5B is an explanatory diagram following FIG. 5A.
[FIG. 6] FIG. 6 is an explanatory diagram following FIG. 5B.
[FIG. 7] FIG. 7 is an explanatory diagram following FIG. 6.

### DESCRIPTION OF THE EMBODIMENTS

### (Overall Configuration)

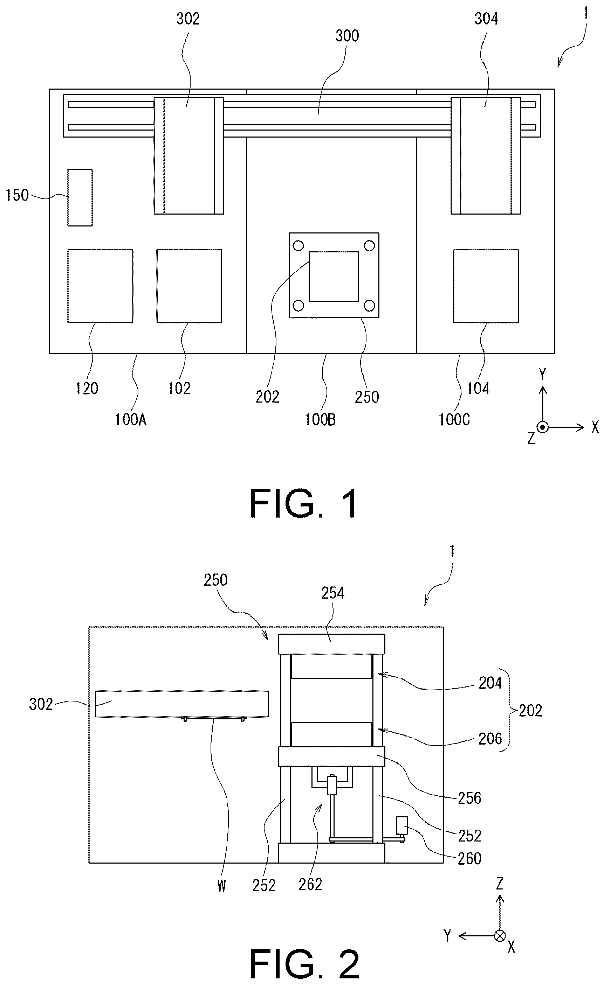

Hereinafter, with reference to the drawings, an embodiment of the present invention will be described in detail. FIG. 1 is a plan view (schematic diagram) showing an example of a compression-molding device 1 according to the present embodiment. For convenience of explanation, in the figure, arrows indicate the left-right direction (X direction), front-back direction (Y direction), and up-down direction (Z direction) in the compression-molding device 1. Moreover, in all figures for explaining each embodiment, the same reference numerals are assigned to members having the same function, and repeated explanations thereof may be omitted.

The compression-molding device 1 according to the present embodiment is a device that performs resin sealing (compression-molding) of a workpiece (object to be molded) W using a sealing mold 202 including an upper mold 204 and a lower mold 206. One or multiple workpiece-holding parts 205 for holding a workpiece W are provided on the lower mold 206. One or multiple cavities 208 are provided on the upper mold 204 according to the shape or number of the workpiece W. A film F is suction-held inside the cavity 208. However, the present invention is not limited to the configuration.

First, the workpiece W, which is the object to be molded, includes a configuration in which electronic parts Wb are mounted on a substrate Wa. More specifically, examples of the substrate Wa include plate-shaped members such as resin substrates, ceramic substrates, metal substrates, carrier plates, lead frames, wafers, etc. Moreover, examples of the electronic parts Wb include semiconductor chips, MEMS chips, passive elements, heat dissipation plates, conductive members, spacers, etc. The shape of the substrate Wa is rectangular (strip-shaped), square, circular, etc. Moreover, the number of the electronic parts Wb mounted on one substrate Wa is set to one or multiple (for example, in a matrix arrangement, etc.).

Examples of methods for mounting the electronic parts Wb on the substrate Wa include methods using wire bonding mounting, flip chip mounting, etc. Alternatively, in a configuration where the substrate (glass or metal carrier plate) Wa is peeled off from a molded product Wp after resin sealing, there is also a method of attaching the electronic parts Wb using a thermally peelable adhesive tape or ultraviolet-curable resin that cures upon ultraviolet irradiation.

In the present embodiment, as a sealing resin R, a solid or semi-solid resin that is a thermosetting resin (for example, epoxy resin containing fillers, but not limited thereto) having a given shape whose overall shape (details to be described later) corresponds to the shape of the workpiece W is configured. Normally, one piece constitutes the "overall" of the required sealing amount (one time per workpiece W), but the configuration in which several pieces (for example, about two or three pieces) in a divided state constitute the "overall" of the required sealing amount may be adopted. The term "semi-solid" refers to a state that is not completely solid but melted to a so-called B-stage.

Moreover, as examples of the film F, film materials with excellent heat resistance, easy peelability, flexibility, and extensibility are preferably used, such as PTFE (polytetrafluoroethylene), ETFE (polytetrafluoroethylene copolymer), PET, FEP, fluorine-impregnated glass cloth, polypropylene, polyvinylidene chloride, etc.

Next, an overview of the compression-molding device 1 according to the present embodiment will be described. As shown in FIG. 1, the compression-molding device 1 includes, as its main components, a supply unit 100A that performs supply of the workpiece W, etc., a press unit 100B that performs resin sealing of the workpiece W and processing it into the molded product Wp, etc., and a storage unit 100C that performs storage of the molded product Wp, etc. As one example, along the X direction in FIG. 1, the supply unit 100A, the press unit 100B, and the storage unit 100C are arranged in this order. However, the present invention is not limited to such configuration, and the equipment configuration within the units, the number of units (especially the number of press units), and the arrangement order of the units may be changed. In addition, a configuration including units other than those mentioned above (all not shown) may also be adopted.

Moreover, the compression-molding device 1 includes a resin supply part 120 that performs supply of the sealing resin R. The resin supply part 120 is, as one example, located in the supply unit 100A, but may be configured to be located in the storage unit 100C or the press unit 100B (not shown). Alternatively, as another example, the resin supply part 120 may be configured to be located outside the compression-molding device 1, and conveyed into the device using a conveyor such as a belt conveyor or a robot hand (not shown).

Moreover, the compression-molding device 1 also has guide rails 300 linearly provided across the units, and a conveyor (first loader) 302 that conveys the workpiece W and the sealing resin R, as well as a conveyor (second loader) 304 that conveys the molded product Wp, are provided to be movable between given units along the guide rails 300. However, the present invention is not limited to the above configuration, and may be configured to include a common (single) conveyor (loader) that conveys the workpiece W, the sealing resin R, and the molded product Wp (not shown). Moreover, the conveyor may be configured to include a robot hand, etc. instead of a loader.

Moreover, the compression-molding device 1 includes a control part 150 located in the supply unit 100A (it may also be configured to be located in other units) that performs operation control of each mechanism in each unit.

### (Supply Unit)

Next, the supply unit 100A included in the compression-molding device 1 will be described in detail.

The supply unit 100A includes a supply magazine 102 in which multiple workpieces W are stored. Here, known stack magazines, slit magazines, etc. are configured as the supply magazine 102.

In addition, the supply unit 100A may be configured to include a workpiece stage (not shown) on which the workpiece W taken out from the supply magazine 102 is placed. Moreover, the supply unit 100A may be configured to include a resin stage (not shown) on which the sealing resin R supplied from the resin supply part 120 is placed.

The workpiece W and the sealing resin R are held by the first loader 302 and conveyed to the press unit 100B, and set at given positions in the sealing mold 202. In this embodiment, the workpiece W is held in a workpiece-holding part 205 of the lower mold 206, and the sealing resin R is placed on top of the workpiece W held in the workpiece-holding part 205 (details of the step will be described later). Moreover, as the holding mechanism for the workpiece W and the sealing resin R in the first loader 302, a known holding mechanism (for example, a configuration having holding claws for gripping, a configuration having suction holes communicating with a suction device to adsorb, etc.) is configured (not shown).

As a modification example of the above conveyor, the configuration may be such that instead of the first loader 302 that moves in the X and Y directions, a conveyor (loader) that moves in the X direction to perform conveyance between units and a conveyor (loader) that moves in the Y direction to perform loading and setting into the sealing mold 202 (not shown) are separately included.

In addition, the supply unit 100A includes a preheater (not shown) that performs preheating of the workpiece W and the sealing resin R. As one example, known heating mechanisms (for example, electric heating wire heaters, infrared heaters, etc.) are configured for the preheater. This allows the workpiece W and the sealing resin R to be preheated before being loaded into the sealing mold 202. A configuration not including a preheater may be adopted. Moreover, the configuration may be such that in the first loader 302, a heater for preheating (not shown) is provided instead of the preheater or together with the preheater.

### (Press Unit)

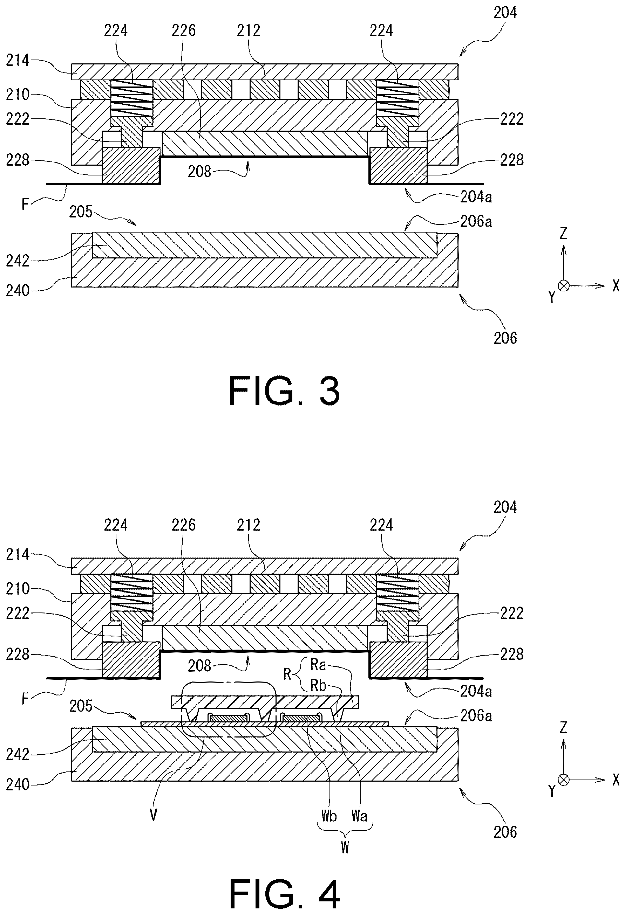

Next, the press unit 100B included in the compression-molding device 1 will be described in detail. Here, FIG. 2 shows a side view (schematic diagram) of a press device 250 provided in the press unit 100B, and FIG. 3 shows a front cross-sectional view (schematic diagram) of the sealing mold 202.

The press unit 100B includes a sealing mold 202 having a pair of molds that open and close (for example, assembled with multiple mold blocks made of alloy tool steel, mold plates, mold pillars, etc., and other components). It also includes a press device 250 that drives the sealing mold 202 to open and close to perform resin sealing of the workpiece W. As one example, the configuration includes one press device 250, but may include multiple press devices (not shown).

Here, as shown in FIG. 2, the press device 250 is configured to include a pair of platens 254, 256, multiple tiebars 252 on which the pair of platens 254, 256 are mounted, and a drive device that makes the platen 256 movable (up and down). Specifically, the drive device is configured to include a drive source (for example, an electric motor) 260 and a drive transmission mechanism (for example, a ball screw or toggle link mechanism) 262, etc. (however, the present invention is not limited thereto). In this embodiment, the platen 254 on the upper side in the vertical direction is set as a fixed platen (a platen fixed to the tiebars 252), and the platen 256 on the lower side is set as a movable platen (a platen that moves up and down while being slidably held on the tiebars 252). However, the present invention is not limited to such configuration, and the arrangement may be reversed vertically. That is, the upper side may be set as the movable platen and the lower side as the fixed platen, or both the upper side and lower side may be set as movable platens (all not shown).

On the other hand, as shown in FIG. 3, the sealing mold 202 includes, as a pair of molds arranged between the pair of platens 254, 256 in the press device 250, one mold (upper mold 204) on the upper side in the vertical direction and another mold (lower mold 206) on the lower side. That is, the upper mold 204 is assembled to the upper platen (in this embodiment, the fixed platen 254), and the lower mold 206 is assembled to the lower platen (in this embodiment, the movable platen 256). Mold closing and mold opening are performed by these upper mold 204 and lower mold 206 approaching and separating from each other (the vertical direction (up-down direction) becomes the mold opening/closing direction).

Moreover, in this embodiment, as one example, a film supply mechanism (not shown) for conveying (supplying) a roll-shaped film F to the inside of the sealing mold 202 is provided. Furthermore, depending on the configuration of the workpiece W, the film F may be in a strip shape instead of a roll shape.

Next, the upper mold 204 of the sealing mold 202 will be described in detail. As shown in FIG. 3, the upper mold 204 includes an upper mold chase 210, and a cavity block 226 held thereby, a clamper 228, and the like. The upper mold chase 210 is fixed to a lower surface of a support plate 214 via support pillars 212. A cavity 208 is provided on a lower surface (the surface facing the lower mold 206) of the upper mold 204.

The clamper 228 is configured in an annular shape to surround the cavity block 226, and is assembled to be spaced apart from (floating) the lower surface of the support plate 214 via push pins 222 and clamper springs (for example, biasing members exemplified by coil springs) 224 so as to be movable up and down (however, the present invention is not limited to this assembly structure). This cavity block 226 constitutes the inner part (bottom part) of the cavity 208, and the clamper 228 constitutes the side part of the cavity 208. Moreover, the shape and number of cavities 208 provided in one upper mold 204 are appropriately set according to the shape and number of workpieces W (one or multiple).

Moreover, a suction path (hole, groove, etc.) communicating with a suction device is provided at the boundary part between the clamper 228 and the cavity block 226 (not shown). This allows the film F supplied from the film supply mechanism to be held by suction on a mold face 204a including the inner surface of the cavity 208. In addition, degassing of the cavity 208 may be performed during mold closing and resin sealing.

Moreover, in this embodiment, an upper mold heating mechanism (not shown) for heating the upper mold 204 to a given temperature is provided. This upper mold heating mechanism includes a heater (for example, an electric heating wire heater), a temperature sensor, a power supply, etc., and the heating is controlled by the control part 150. As one example, the heater is built into the upper mold chase 210 and is configured to apply heat to the overall upper mold 204 and the sealing resin R contained in the cavity 208. The upper mold 204 is heated by the heater to a given temperature (for example, 100°C to 300°C).

Next, the lower mold 206 of the sealing mold 202 will be described in detail. As shown in FIG. 3, the lower mold 206 includes a lower mold chase 240, and a lower plate 242 held thereby, and the like.

Moreover, in this embodiment, a workpiece-holding part 205 for holding the workpiece W at a given position on an upper surface of the lower plate 242 is provided. This workpiece-holding part 205, as one example, has a workpiece guide pin (not shown), and a suction path (hole, groove, etc.) that is arranged to penetrate through the lower plate 242 and communicates with a suction device (not shown). This allows the workpiece W to be held by suction on a mold face 206a. Specifically, one end of the suction path leads to the mold face 206a of the lower mold 206, and the other end is connected to the suction device arranged outside the lower mold 206. This makes it possible to drive the suction device to suction the workpiece W through the suction path and hold the workpiece W by suction on the mold face 206a (here, the upper surface of the lower plate 242). The configuration may be such that the holding claws for holding the outer periphery of the workpiece W (not shown) is provided instead of the suction holding mechanism or together with the suction holding mechanism. The shape and number of workpiece-holding parts 205 provided in one lower mold 206 are appropriately set according to the shape and number of the workpieces W (one or multiple).

Moreover, in this embodiment, a lower mold heating mechanism (not shown) for heating the lower mold 206 to a given temperature is provided. This lower mold heating mechanism includes a heater (for example, an electric heating wire heater), a temperature sensor, a power supply, etc., and the heating is controlled by the control part 150. As one example, the heater is built into the lower mold chase 240 and is configured to apply heat to the overall lower mold 206 and the workpiece W held by the workpiece-holding part 205. The lower mold 206 is heated by the heater to a given temperature (for example, 100°C to 300°C).

### (Storage Unit)

Next, the storage unit 100C included in the compression-molding device 1 will be described in detail.

The molded product Wp is held by the second loader 304, unloaded from the sealing mold 202, and conveyed to the storage unit 100C. Moreover, as the holding mechanism for the molded product Wp in the second loader 304, a known holding mechanism (for example, a configuration having holding claws for gripping, a configuration having suction holes communicating with a suction device to adsorb, etc.) is configured (not shown).

As a modification example of the above conveyor, the configuration may be such that instead of the second loader 304 that moves in the X and Y directions, a conveyor (loader) that moves in the X direction to perform conveyance between units and a conveyor (loader) that moves in the Y direction to perform unloading from the sealing mold 202 (not shown) are separately included.

The storage unit 100C includes a storage magazine 104 in which multiple molded products Wp are stored. Here, known stack magazines, slit magazines, etc. are configured for the storage magazine 104.

The storage unit 100C may also be configured to include a molded product stage (not shown) on which the molded product Wp conveyed from the press unit 100B is placed.

### (Resin Sealing Operation)

Next, the operation of performing resin sealing (compression-molding) using the compression-molding device 1 according to the present embodiment (that is, the compression-molding method according to the present embodiment) will be described. Here, FIG. 4 to FIG. 7 are explanatory diagrams of each step, shown as front sectional views in the same direction as FIG. 3.

First, as a preparation step, a heating step (upper mold heating step) is performed to heat the upper mold 204 to a given temperature (for example, 100°C to 300°C) by adjusting it using the upper mold heating mechanism. Moreover, a heating step (lower mold heating step) is performed to heat the lower mold 206 to a given temperature (for example, 100°C to 300°C) by adjusting it using the lower mold heating mechanism. In addition, a film setting step is performed to set a new film F inside the sealing mold 202 by operating the film supply mechanism.

Before, after, or in parallel with the above preparation step, a resin preparation step is performed to prepare, as the sealing resin R for sealing, a solid or semi-solid resin having a given shape whose overall shape (to be described later) corresponds to the shape of the workpiece W.

Next, a workpiece holding step is performed to hold the workpiece W in the workpiece-holding part 205 of the lower mold 206. Specifically, the workpiece W supplied from the supply magazine 102 is held by the first loader 302, loaded into the sealing mold 202, and held in the workpiece-holding part 205.

After the workpiece holding step, a resin placement step is performed to place the sealing resin R prepared in the resin preparation step on top of the workpiece W held in the workpiece-holding part 205 (see FIG. 4). Specifically, the sealing resin R supplied from the resin supply part 120 is held by the first loader 302, loaded into the sealing mold 202, and placed on top of the workpiece W held in the workpiece-holding part 205.

Alternatively, as another example of the resin placement step, it may be performed as a step of placing the sealing resin R prepared in the resin preparation step on top of the workpiece W before the above workpiece holding step. In that case, the workpiece holding step is a step of holding the workpiece W with the sealing resin R already placed thereon in the workpiece-holding part 205. That is, the first loader 302 holds the workpiece W with the sealing resin R placed thereon, loads it into the sealing mold 202, and holds it in the workpiece-holding part 205. This has an advantage the workpiece W and the sealing resin R are loaded into the sealing mold 202 at one time, rather than separately.

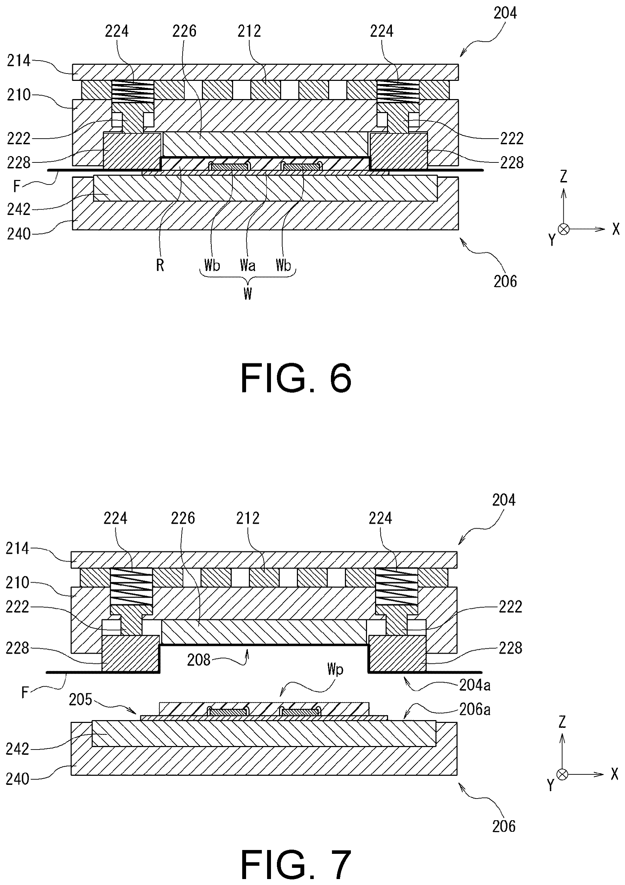

Next, a step is performed to process the workpiece W into a molded product Wp by sealing it with the sealing resin R. First, a mold closing step is performed to close the sealing mold 202 and relatively lower the cavity block 226 inside the cavity 208 to heat and pressurize the sealing resin R against the workpiece W. As a result, the sealing resin R thermally cures, completing the resin sealing (compression-molding) (see FIG. 6).

As described above, for example, in conventional compression-molding devices where a cavity is provided in the upper mold for workpieces W mounted with a strip type wire-connected electronic parts (semiconductor chips) Wb, there was a problem that resin sealing was difficult because the wire part of the workpiece held in the lower mold would deform due to contact with the sealing resin supplied in advance to the cavity or supplied on the workpiece during the mold closing step. Therefore, for such workpieces W, compression-molding devices with cavities provided in the lower mold were generally adopted. However, there were also issues (as mentioned above) inherent to the configuration where the cavity is provided in the lower mold.

In response to the above issues, the compression-molding device 1 according to the present embodiment is configured such that the cavity 208 is provided in the upper mold 204, and adopts a configuration in which solid or semi-solid resin formed into a given shape corresponding to the shape of the workpiece W is configured as the sealing resin R, thereby making it possible to solve these problems.

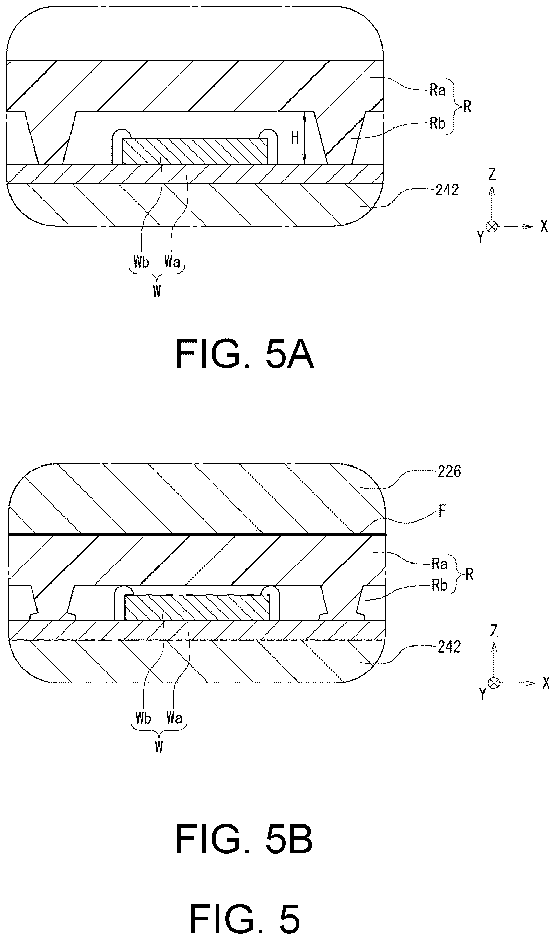

Specifically, the "given shape" is a shape that does not contact the electronic parts Wb (for electronic parts Wb with wires, including the wires) when placed on the substrate Wa of the workpiece W. As one example, as shown in FIG. 4, a sealing resin R having a shape provided with a plate-shaped or block-shaped main body part Ra and legs Rb discontinuously (or continuously) erected on one face of the main body part Ra (the face facing the electronic parts Wb of the workpiece W) is preferable (but the present invention is not limited to this shape). The main body part Ra is sized to fit inside the cavity 208 in plan view, and considering resin flow, a size slightly smaller than the shape of the cavity 208 (especially the cavity block 226) is preferable. Moreover, while the legs Rb need to have a height H (see FIG. 5A) that does not contact the electronic parts Wb, this does not exclude contact to the extent that does not cause plastic deformation of the wires. In addition, the legs Rb are positioned at locations that do not contact the electronic parts Wb in plan view of the main body part Ra, and are positioned such that the main body part Ra does not tilt when placed on the workpiece W. Furthermore, a configuration where they are arranged between the electronic parts Wb or at the outer peripheral positions of the electronic parts Wb is preferable to prevent any damage to the wiring (especially wires) of the workpiece W during molding. Moreover, the total resin amount of the plate-shaped or block-shaped main body part Ra and the legs Rb may be an amount without excess or deficiency, sufficient for one compression-molding operation, or it may be a larger amount of resin.

According to the above configuration, during the implementation of the mold closing step, as shown in the transition from FIG. 5A to FIG. 5B, the softening and melting of the sealing resin R progresses due to heating (note that FIG. 5A and FIG. 5B are shown as enlarged views of section V in FIG. 4). At this time, the resin (specifically, the main body part Ra) uniformly contacts all wires (see FIG. 5B). As a result, the effect of suppressing wire flow is obtained.

The inventor of the present invention actually conducted experiments using the compression-molding device 1 according to the present embodiment, and confirmed that wire flow was suppressed and molding quality was improved compared to a conventional compression-molding device where the workpiece is held on the upper mold, the cavity is provided in the lower mold, and the sealing resin (specifically, granular resin) is supplied to the cavity.

Furthermore, because the sealing resin R is a solid or semi-solid resin, it is also possible to solve issues such as uneven scattering, residual air, and dust generation caused by granular resin as in conventional methods, as well as the difficulty in handling. In addition, even when forming thick molded products with a thickness dimension exceeding 1 mm, it is possible to prevent the film F from biting into the molded product Wp.

Note that the steps following the above-described mold closing step are the same as in the conventional compression-molding method. In outline, a mold opening step is performed to open the sealing mold 202 and separate the molded product Wp from the used film F (see FIG. 7). Subsequently, a molded product unloading step is performed in which the second loader 304 unloads the molded product Wp from the sealing mold 202 to the storage unit 100C. Furthermore, after or in parallel with the molded product unloading step, a film setting step is performed in which the film supply mechanism is activated to feed out the used film F from the sealing mold 202 and feed in a new film F into the sealing mold 202.

The above are the main steps of the compression-molding method performed using the compression-molding device 1. However, the order of the steps is just one example, and changes in sequence or parallel implementation are possible as long as there is no hindrance.

As described above, according to the present invention, by adopting a configuration where the cavity is provided in the upper mold, it is possible to solve the aforementioned issues in the configuration where the cavity is provided in the lower mold. In particular, it is possible to prevent the occurrence of molding failures caused by sealing resin flow, uneven scattering, and residual air. In addition, it is possible to facilitate the handling of the sealing resin while preventing the generation of dust. Furthermore, it is possible to form not only thin molded products (with a thickness dimension less than 1 mm) but also thick molded products (with a thickness dimension of 1 mm or more). In addition, although the upper limit of the thickness dimension depends on various setting conditions, it is considered that formation up to about 10 mm is sufficiently possible.

Furthermore, the present invention is not limited to the above-described embodiments and may be variously modified within a range that does not deviate from the present invention.

## Claims

1. A compression-molding device for processing a workpiece into a molded product by sealing it with a sealing resin by using a sealing mold including an upper mold having a cavity and a lower mold having a workpiece-holding part, the compression-molding device comprising:
a conveyor that places the sealing resin on top of the workpiece held in the workpiece-holding part, or holds the workpiece with the sealing resin placed thereon in the workpiece-holding part,
wherein as the sealing resin, a solid or semi-solid resin having a given shape whose overall shape corresponds to a shape of the workpiece is configured.

2. The compression-molding device according to claim 1, wherein as the workpiece, a workpiece having a configuration in which an electronic part is mounted on a substrate is configured, and
as the sealing resin, a solid or semi-solid resin formed in a shape that does not contact the electronic part when placed on the substrate is configured.

3. The compression-molding device according to claim 1 or claim 2, wherein as the sealing resin, a solid or semi-solid resin having a plate-shape or block-shape main body part and a leg erected on one face of the main body part is configured.

4. A compression-molding method for processing a workpiece into a molded product by sealing it with a sealing resin by using a sealing mold including an upper mold having a cavity and a lower mold having a workpiece-holding part, the method comprising:
a resin preparation step of preparing, as the sealing resin, a solid or semi-solid resin having a given shape whose overall shape corresponds to a shape of the workpiece;
a workpiece holding step of holding the workpiece in the workpiece-holding part; and
a resin placement step of placing the sealing resin on top of the workpiece after or before the workpiece holding step.

5. The compression-molding method according to claim 4, wherein as the workpiece, a workpiece having a configuration in which an electronic part is mounted on a substrate is configured, and
as the sealing resin, a solid or semi-solid resin formed in a shape that does not contact the electronic part when placed on the substrate is configured.

6. The compression-molding method according to claim 4 or claim 5, wherein as the sealing resin, a solid or semi-solid resin having a plate-shape or block-shape main body part and a leg erected on one face of the main body part is configured.
